# EUROPEAN PATENT APPLICATION

(11) **EP 4 297 006 A1**
(43) Date of publication of application: **27.12.2023**
(21) Application number: 23180950.0
(22) Date of filing: 22.06.2023
(51) Int. Cl.: G09G 3/32, G01R 31/26, G09G 3/3233, H01L 25/00, H01L 25/075, H05B 45/00, H10K 59/131, H10K 71/70

(54) **DISPLAY DEVICE**

(30) Priority: 22.06.2022 KR 20220076441
(71) Applicant: Samsung Display Co., Ltd., Yongin-si, Gyeonggi-do 17113 (KR)
(72) Inventor: PARK, Do Yeong, 17113 Yongin-si (KR); KIM, Kyung Bae, 17113 Yongin-si (KR); LEE, Won Jun, 17113 Yongin-si (KR); CHANG, Jong Woong, 17113 Yongin-si (KR)
(74) Representative: Marks & Clerk LLP

(57) **Abstract**

A display device includes electrodes (ALE) spaced from each other in a display area (DA), light emitting elements between the electrodes (ALE), test electrodes (TEL) spaced from each other in a test area (TA), and a test transistor (TTR1, TTR2) electrically connected to the electrodes (ALE) and the test electrodes (TEL).

## Description

### BACKGROUND

### 1. Field

The present disclosure relates to a display device.

### 2. Description of the Related Art

Recently, as interest in an information display is increasing, research and development for a display device are continuously being conducted.

### SUMMARY

Aspects and features of embodiments of the present disclosure are to provide a display device capable of reducing or minimizing deterioration of alignment of light emitting elements due to a short circuit defect of test electrodes.

Aspects and features of embodiments of the present disclosure are not limited to the above-described aspects and features and other aspects and features that are not described will be clearly understood by those skilled in the art from the following description.

According to one or more embodiments of the present disclosure, a display device includes electrodes spaced from each other in a display area, light emitting elements between the electrodes, test electrodes spaced from each other in a test area, and a test transistor electrically connected to the electrodes and the test electrodes.

The electrodes and the test electrodes may include a same conductive layer.

The electrodes and the test electrodes may extend in a same direction.

A first transistor electrode of the test transistor may be in contact with the test electrodes, and a second transistor electrode of the test transistor may be in contact with the electrodes.

The display device may further include a test line connected to the test transistor.

The display device may further include signal lines connected to the electrodes.

The test line and the signal lines may be electrically separated from each other.

The display device may further include a test pad connected to the test line.

The display device may further include connection electrodes on the light emitting elements to be in contact with the light emitting elements.

According to one or more embodiments of the present disclosure, a display device includes a first electrode and a second electrode spaced from each other in a display area, light emitting elements between the first and second electrodes, and s first test electrode and a second test electrode spaced from each other in a test area. The first electrode at least partially overlaps the first test electrode, and the second electrode at least partially overlaps the second test electrode.

The first electrode and the first test electrode may include different conductive layers.

The first electrode may be in contact with the first test electrode through a contact hole.

According to one or more embodiments of the present disclosure, a display device includes electrodes spaced from each other in a display area, light emitting elements between the electrodes, test electrodes spaced from each other in a test area, and a conductive pattern between the electrodes and the test electrodes.

The electrodes and the test electrodes may include a same conductive layer.

The conductive pattern may be on the electrodes and/or the test electrodes.

One end of the conductive pattern may be in contact with the electrodes, and another end of the conductive pattern may be in contact with the test electrodes.

The electrodes may include an open portion overlapping the conductive pattern.

The test electrodes may include an open portion overlapping the conductive pattern.

The conductive pattern may include a material that is different from that of the electrodes and/or the test electrodes.

The electrodes and the test electrodes may be spaced from each other.

Details of other embodiments are included in the detailed description and drawings.

According to the above-described embodiment, the test electrodes may be connected to the electrodes only when pre-alignment monitoring is required. Therefore, because an alignment signal of pixels may be prevented from being affected even though a short defect occurs, alignment deterioration may be prevented.

At least some of the above and other features of the invention are set out in the claims.

Effects, aspects, and features of embodiments of the present disclosure are not limited by the contents illustrated above, and more various effects, aspects, and features are included in the present specification.

### BRIEF DESCRIPTION OF THE DRAWINGS

The above and other aspects and features of the present disclosure will become more apparent by describing in further detail embodiments thereof with reference to the accompanying drawings, in which:
FIG. 1 is a perspective view illustrating a light emitting element according to one or more embodiments;
FIG. 2 is a cross-sectional view illustrating a light emitting element according to one or more embodiments;
FIGS. 3 and 4 are plan views illustrating a display panel according to one or more embodiments;
FIG. 5 is a circuit diagram illustrating a pixel according to one or more embodiments;
FIGS. 6 and 7 are plan views illustrating a pixel according to one or more embodiments;
FIG. 8 is a plan view illustrating a first test transistor according to one or more embodiments;
FIG. 9 is a plan view illustrating a second test transistor according to one or more embodiments;
FIG. 10 is a cross-sectional view taken along the line A-A' of FIG. 6;
FIG. 11 is a cross-sectional view taken along the line B-B' of FIG. 6;
FIG. 12 is a cross-sectional view taken along the line C-C' of FIG. 7;
FIG. 13 is a cross-sectional view taken along the line D-D' of FIG. 7;
FIG. 14 is a cross-sectional view illustrating first to third pixels according to one or more embodiments;
FIG. 15 is a cross-sectional view of a pixel according to one or more embodiments;
FIG. 16 is a plan view illustrating a display panel according to one or more embodiments;
FIGS. 17 and 18 are plan views illustrating a test area according to one or more embodiments; and
FIGS. 19 and 20 are plan views illustrating a test area according to one or more embodiments.

### DETAILED DESCRIPTION

Aspects and features of embodiments of the present disclosure and a method of achieving them will become apparent with reference to the embodiments described in detail below together with the accompanying drawings. However, the present disclosure is not limited to the embodiments disclosed below, and may be implemented in various different forms. The present embodiments are provided so that the present disclosure will be thorough and complete and those skilled in the art to which the present disclosure pertains can fully understand the scope of the present disclosure. The present disclosure is defined by the scope of the claims and their equivalents.

The terms used in the present specification are for describing embodiments and are not intended to limit the present disclosure. In the present specification, the singular form also includes the plural form unless otherwise specified. The term "comprises" and/or "comprising" does not exclude presence or addition of one or more other components, steps, operations, and/or elements to the described component, step, operation, and/or element.

In addition, the term "coupling" or "connection" may collectively mean a physical and/or electrical coupling or connection. In addition, this may collectively mean a direct or indirect coupling or connection and an integral or non-integral coupling or connection.

A case in which an element or a layer is referred to as "on" another element or layer includes a case in which another layer or another element is disposed directly on the other element or between the other layers. The same reference numerals denote to the same components throughout the specification.

Although a first, a second, and the like are used to describe various components, these components are not limited by these terms. These terms are used only to distinguish one component from another component. Therefore, a first component described below may be a second component within the technical context of the present disclosure.

Hereinafter, embodiments of the present disclosure are described in detail with reference to the accompanying drawings.

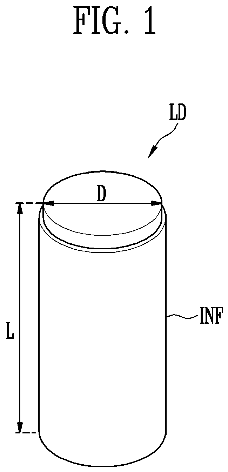

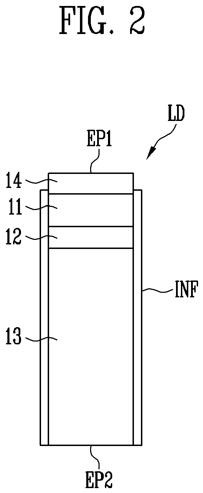

FIG. 1 is a perspective view illustrating a light emitting element according to one or more embodiments. FIG. 2 is a cross-sectional view illustrating a light emitting element according to one or more embodiments. FIGS. 1 and 2 show a column shape light emitting element LD, but a type and/or a shape of the light emitting element LD are/is not limited thereto.

Referring to FIGS. 1 and 2, the light emitting element LD may include a first semiconductor layer 11, an active layer 12, a second semiconductor layer 13, and/or an electrode layer 14.

The light emitting element LD may be formed in a column shape extending along one direction. The light emitting element LD may have a first end EP1 and a second end EP2. One of the first and second semiconductor layers 11 and 13 may be disposed at the first end EP1 of the light emitting element LD. The other one of the first and second semiconductor layers 11 and 13 may be disposed at the second end EP2 of the light emitting element LD. For example, the first semiconductor layer 11 may be disposed at the first end EP1 of the light emitting element LD, and the second semiconductor layer 13 may be disposed at the second end EP2 of the light emitting element LD.

According to one or more embodiments, the light emitting element LD may be a light emitting element manufactured in a column shape through an etching method or the like. In the present specification, the column shape includes a rod-like shape or a bar-like shape of which an aspect ratio is greater than 1, such as a circular column or a polygonal column, and the shape of the cross-section thereof is not limited.

The light emitting element LD may have a size as small as a nanometer scale to a micrometer scale. For example, each light emitting element LD may have a diameter D (or width) and/or a length L of a nanometer scale to micrometer scale range. However, a size of the light emitting element LD is not limited thereto, and the size of the light emitting element LD may be variously changed according to a design condition of various devices using a light emitting device using the light emitting element LD as a light source, for example, a display device or the like.

The first semiconductor layer 11 may be a semiconductor layer of a first conductivity type. For example, the first semiconductor layer 11 may include a p-type semiconductor layer. For example, the first semiconductor layer 11 may include at least one semiconductor material from among InAlGaN, GaN, AlGaN, InGaN, or AlN, and may include a p-type semiconductor layer doped with a first conductivity type dopant such as Mg. However, a material configuring the first semiconductor layer 11 is not limited thereto, and various other materials may configure the first semiconductor layer 11.

The active layer 12 may be disposed between the first semiconductor layer 11 and the second semiconductor layer 13. The active layer 12 may include any one of a single well structure, a multi well structure, a single quantum well structure, a multi quantum well (MQW) structure, a quantum dot structure, or a quantum wire structure, but is not limited thereto. The active layer 12 may include GaN, InGaN, InAlGaN, AlGaN, or AlN, and various other materials may configure the active layer 12.

When a voltage equal to or greater than a threshold voltage is applied between both ends of the light emitting element LD, an electron-hole pair is combined in the active layer 12 and thus the light emitting element LD emits light. By controlling emission of the light emitting element LD using such a principle, the light emitting element LD may be used as a light source of various light emitting devices including a pixel of a display device.

The second semiconductor layer 13 may be disposed on the active layer 12 and may include a semiconductor layer of a type different from that of the first semiconductor layer 11. The second semiconductor layer 13 may include an n-type semiconductor layer. For example, the second semiconductor layer 13 may include any one semiconductor material from among InAlGaN, GaN, AlGaN, InGaN, and AIN, and may include an n-type semiconductor layer doped with a second conductivity type dopant such as Si, Ge, and Sn. However, a material configuring the second semiconductor layer 13 is not limited thereto, and various other materials may configure the second semiconductor layer 13.

The electrode layer 14 may be disposed on the first end EP1 and/or the second end EP2 of the light emitting element LD. FIG. 2 illustrates a case in which the electrode layer 14 is formed on the first semiconductor layer 11, but the present disclosure is not limited thereto. For example, a separate contact electrode may be further disposed on the second semiconductor layer 13.

The electrode layer 14 may include a transparent metal or a transparent metal oxide. For example, the electrode layer 14 may include at least one of indium tin oxide (ITO), indium zinc oxide (IZO), and zinc tin oxide (ZTO), but is not limited thereto. As described above, when the electrode layer 14 is formed of the transparent metal or the transparent metal oxide, light generated in the active layer 12 of the light emitting element LD may pass through the electrode layer 14 and may be emitted to an outside of the light emitting element LD.

An insulating layer INF may be provided on a surface (e.g., an outer peripheral or circumferential surface) of the light emitting element LD. The insulating layer INF may be directly disposed on a surface (e.g., an outer peripheral or circumferential surface) of the first semiconductor layer 11, the active layer 12, the second semiconductor layer 13, and/or the electrode layer 14. The insulating layer INF may expose the first and second ends EP1 and EP2 of the light emitting element LD having different polarities. According to one or more embodiments, the insulating layer INF may expose a side portion of the electrode layer 14 and/or the second semiconductor layer 13 adjacent to the first and second ends EP1 and EP2 of the light emitting element LD.

The insulating layer INF may prevent an electrical short that may occur when the active layer 12 comes into contact with a conductive material except for the first and second semiconductor layers 11 and 13. In addition, the insulating layer INF may reduce or minimize a surface defect of the light emitting elements LD, thereby improving lifespan and emission efficiency of the light emitting elements LD.

The insulating layer INF may include at least one of silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx). For example, the insulating layer INF may be configured as double layers, and each layer configuring the double layers may include different materials. For example, the insulating layer INF may be configured as double layers configured of aluminum oxide (AlOx) and silicon oxide (SiOx), but is not limited thereto. According to one or more embodiments, the insulating layer INF may be omitted.

A light emitting device including the light emitting element LD described above may be used in various types of devices that require a light source, including a display device. For example, the light emitting elements LD may be disposed in each pixel of a display panel, and the light emitting elements LD may be used as a light source of each pixel. However, an application field of the light emitting element LD is not limited to the above-described example. For example, the light emitting element LD may also be used in other types of devices that require a light source, such as a lighting device.

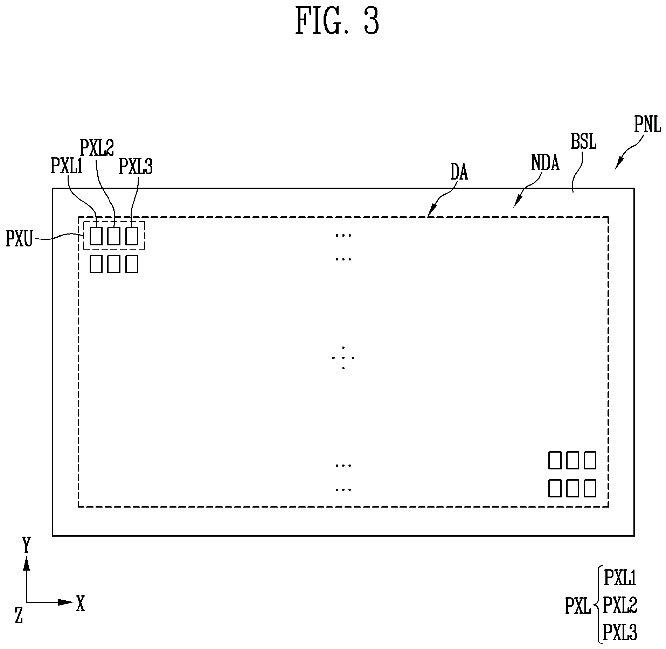

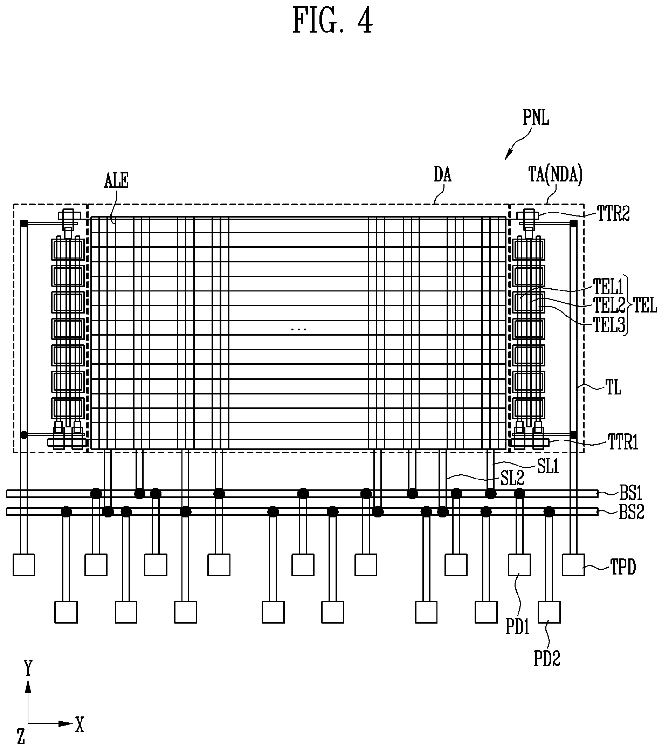

FIGS. 3 and 4 are plan views illustrating a display panel according to one or more embodiments.

In FIGS. 3 and 4, as an example of an electronic device that may use the light emitting element LD described in the embodiments of FIGS. 1 and 2 as a light source, a display device, particularly, a display panel PNL provided in the display device is shown.

Referring to FIGS. 3 and 4, the display panel PNL and a base layer BSL for forming the same may include the display area DA for displaying an image and a non-display area NDA except for the display area DA around an edge or periphery of the display area DA. The display area DA may configure a screen on which the image is displayed, and the non-display area NDA may be an area except for the display area DA where no image is displayed.

A pixel unit PXU may be disposed in the display area DA. The pixel unit PXU may include a first pixel PXL1, a second pixel PXL2, and/or a third pixel PXL3. Hereinafter, when at least one pixel from among the first pixel PXL1, the second pixel PXL2, and the third pixel PXL3 is arbitrarily referred to, or when two or more types of pixels are collectively referred to, the at least one pixel or the two or more types of pixels are referred to as a "pixel PXL" or "pixels PXL".

The pixels PXL may be regularly arranged according to a stripe or a PENTILE^{®} arrangement structure, but the present disclosure is not limited thereto. This PENTILE^{®} arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea. However, an arrangement structure of the pixels PXL is not limited thereto, and the pixels PXL may be arranged in the display area DA in various structures and/or methods.

According to one or more embodiments, two or more types of pixels PXL for emitting light of different colors may be disposed in the display area DA. For example, in the display area DA, the first pixels PXL1 that emit light of a first color, the second pixels PXL2 to emit light of a second color, and the third pixels PXL3 to emit light of a third color may be arranged. At least one of the first to third pixels PXL1, PXL2, and PXL3 disposed to be adjacent to each other may configure one pixel unit PXU capable of emitting light of various colors. For example, each of the first to third pixels PXL1, PXL2, and PXL3 may be a pixel for emitting light of a desired color (e.g., a predetermined color). According to one or more embodiments, the first pixel PXL1 may be a red pixel to emit red light, the second pixel PXL2 may be a green pixel to emit green light, and the third pixel PXL3 may be a blue pixel to emit blue light, but are not limited thereto.

In one or more embodiments, the first pixel PXL1, the second pixel PXL2, and the third pixel PXL3 may include light emitting elements that emit light of the same color, and may include a color conversion layer and/or a color filter layer of different colors disposed on the respective light emitting elements, to emit light of the first color, the second color, and the third color, respectively. In one or more embodiments, the first pixel PXL1, the second pixel PXL2, and the third pixel PXL3 may include a light emitting element of the first color, a light emitting element of the second color, and a light emitting element of the third color as a light source, to emit light of the first color, the second color, and the third color, respectively. However, the color, type, number, and/or the like of the pixels PXL configuring each pixel unit PXU are/is not particularly limited. That is, the color of light emitted by each pixel PXL may be variously changed.

The pixel PXL may include at least one light source driven by a suitable control signal (e.g., a predetermined control signal, for example, a scan signal and a data signal) and/or a suitable power (e.g., a predetermined power, for example, first power and second power). In one or more embodiments, the light source may include at least one light emitting element LD according to any one of the embodiments of FIGS. 1 and 2, for example, an ultra-small column shape light emitting elements LD having a size as small as a nanometer scale to a micrometer scale. However, the present disclosure is not limited thereto, and various types of light emitting elements LD may be used as the light source of the pixel PXL.

In one or more embodiments, each pixel PXL may be configured as an active pixel. However, a type, a structure, and/or a driving method of the pixel PXL applicable to the display device are/is not particularly limited. For example, each pixel PXL may be configured as a pixel of a passive or active light emitting display device of various structures and/or driving methods.

Signal lines SL1 and SL2 may be disposed in the non-display area NDA. A first signal lines SL1 may be electrically connected to first pads PD1 through first bus lines BS1. The first signal lines SL1 may serve to provide the first power applied to the first pads PD1 to the pixel PXL. In addition, the first signal lines SL1 may provide a first alignment signal provided in a step of aligning the light emitting elements LD to the pixel PXL during a manufacturing process of the display panel PNL to electrodes ALE of the pixels PXL. To this end, the first signal lines SL1 may be connected to the electrodes ALE of each of the pixels PXL.

The second signal lines SL2 may be electrically connected to second pads PD2 through second bus lines BS2. The second signal lines SL2 may serve to provide the second power applied to the second pads PD2 to the pixel PXL. In addition, the second signal lines SL2 may provide a second alignment signal provided in the step of aligning the light emitting elements LD to the pixel PXL in the manufacturing process of the display panel PNL to the electrodes ALE of the pixels PXL. To this end, the second signal lines SL2 may be connected to the electrodes ALE of each of the pixels PXL. For example, the first alignment signal may be a ground voltage, and the second alignment signal may be an AC voltage, but the present disclosure is not limited thereto.

A test area TA may be disposed in the non-display area NDA. The test area TA may be an area where test elements for monitoring alignment before a printing process of the above-described light emitting elements LD are provided. For example, test electrodes TEL, test transistors TTR1 and TTR2, test lines TL, and/or test pads TPD may be disposed in the test area TA. The test electrodes TEL may extend along a second direction (Y-axis direction) and may be spaced from each other along a first direction (X-axis direction). For example, each of first to third test electrodes TEL1, TEL2, and TEL3 may extend along the second direction (Y-axis direction), and may be sequentially disposed to be spaced along the first direction (X-axis direction), but is not limited thereto.

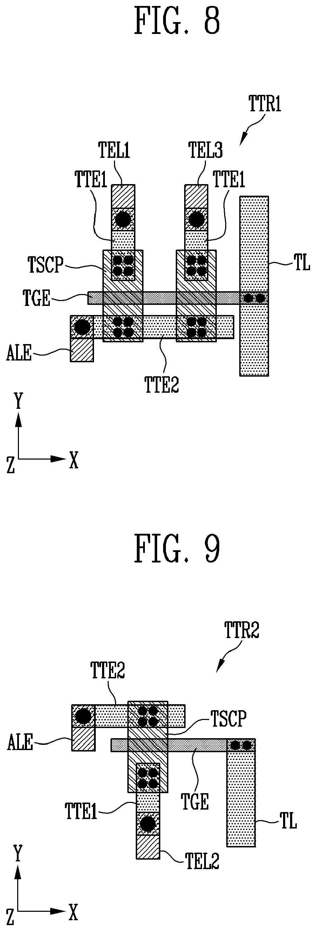

The test transistors TTR1 and TTR2 may be electrically connected to the above-described electrodes ALE and/or test electrodes TEL. For example, a first test transistor TTR1 may be electrically connected to the electrodes ALE and/or the first and third test electrodes TEL1 and TEL3. In addition, a second test transistor TTR2 may be electrically connected to the electrodes ALE and/or the second test electrode TEL2. As described above, when the test electrodes TEL are electrically connected to the electrodes ALE through the test transistors TTR1 and TTR2, the test transistors TTR1 and TTR2 may be turned on only when pre-alignment monitoring is required. For example, when a gate signal is supplied to the test line TL, the test transistors TTR1 and TTR2 may be turned on, and the test electrodes TEL may be connected to the electrodes ALE to perform a pre-alignment test. Therefore, even though a short defect occurs between the test electrodes TEL, an effect on an alignment signal of the pixels PXL may be prevented, thereby preventing alignment deterioration. A detailed description of the test transistors TTR1 and TTR2 is described later with reference to FIGS. 8 and 9.

The test lines TL may be connected to the test pads TPD to provide a test signal applied to the test pads TPD to the test transistors TTR1 and TTR2. The test lines TL may be electrically separated from the above-described signal lines SL1 and SL2.

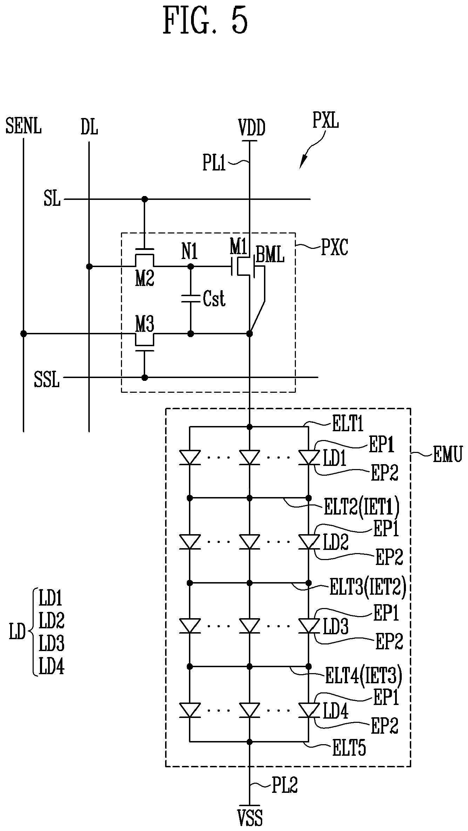

FIG. 5 is a circuit diagram illustrating a pixel according to one or more embodiments.

The pixel PXL shown in FIG. 5 may be any one of the first pixel PXL1, the second pixel PXL2, and the third pixel PXL3 provided in the display panel PNL of FIG. 3. The first pixel PXL1, the second pixel PXL2, and the third pixel PXL3 may have structures substantially identical or similar to each other.

Referring to FIG. 5, each pixel PXL may further include a light emitting unit EMU for generating light of a luminance corresponding to a data signal, and a pixel circuit PXC for driving the light emitting unit EMU.

The pixel circuit PXC may be connected between first power VDD and the light emitting unit EMU. In addition, the pixel circuit PXC may be connected to a scan line SL and a data line DL of the corresponding pixel PXL, and may control an operation of the light emitting unit EMU in response to a scan signal and a data signal supplied from the scan line SL and the data line DL. In addition, the pixel circuit PXC may be further selectively connected to a sensing signal line SSL and a sensing line SENL.

The pixel circuit PXC may include at least one transistor and a capacitor. For example, the pixel circuit PXC may include a first transistor M1, a second transistor M2, a third transistor M3, and a storage capacitor Cst.

The first transistor M1 may be connected between the first power VDD and a first connection electrode ELT1. A gate electrode of the first transistor M1 may be connected to a first node N1. The first transistor M1 may control a driving current supplied to the light emitting unit EMU in response to a voltage of the first node N1. That is, the first transistor M1 may be a driving transistor that controls the driving current of the pixel PXL.

In one or more embodiments, the first transistor M1 may selectively include a lower conductive layer BML (also referred to as a "lower electrode", a "back gate electrode", or a "lower light blocking layer"). The gate electrode of the first transistor M1 and the lower conductive layer BML may overlap each other with an insulating layer interposed therebetween. In one or more embodiments, the lower conductive layer BML may be connected to one electrode of the first transistor M1, for example, a source or drain electrode.

In a case where the first transistor M1 includes the lower conductive layer BML, when driving the pixel PXL, a back-biasing technology (or sync technology) of moving a threshold voltage of the first transistor M1 in a negative direction or a positive direction by applying a back-biasing voltage to the lower conductive layer BML of the first transistor M1 may be applied. For example, the threshold voltage of the first transistor M1 may move in the negative direction or the positive direction by applying a source-sync technology by connecting the lower conductive layer BML to the source electrode of the first transistor M1. In addition, when the lower conductive layer BML is disposed under a semiconductor pattern configuring a channel of the first transistor M1, the lower conductive layer BML may serve as a light blocking pattern and stabilize an operation characteristic of the first transistor M1. However, a function and/or a utilization method of the lower conductive layer BML are/is not limited thereto.

The second transistor M2 may be connected between the data line DL and the first node N1. In addition, a gate electrode of the second transistor M2 may be connected to the scan line SL. The second transistor M2 may be turned on when a scan signal of a gate-on voltage (for example, a high level voltage) is supplied from the scan line SL, to electrically connect the data line DL and the first node N1.

For each frame period, a data signal of a corresponding frame may be supplied to the data line DL, and the data signal may be transmitted to the first node N1 through the turned on second transistor M2 during a period in which the scan signal of the gate-on voltage is supplied. That is, the second transistor M2 may be a switching transistor for transmitting each data signal to an inside of the pixel PXL.

One electrode of the storage capacitor Cst may be connected to the first node N1, and another electrode may be connected to the second electrode of the first transistor M1. The storage capacitor Cst may charge a voltage corresponding to the data signal supplied to the first node N1 during each frame period.

The third transistor M3 may be connected between the first connection electrode ELT1 (or the second electrode of the first transistor M1) and the sensing line SENL. A gate electrode of the third transistor M3 may be connected to the sensing signal line SSL. The third transistor M3 may transmit a voltage value applied to the first connection electrode ELT1 to the sensing line SENL according to a sensing signal supplied to the sensing signal line SSL. The voltage value transmitted through the sensing line SENL may be provided to an external circuit (for example, a timing controller), and the external circuit may extract characteristic information (for example, the threshold voltage or the like of the first transistor M1) of each pixel PXL based on the provided voltage value. The extracted characteristic information may be used to convert image data so that a characteristic deviation between the pixels PXL is compensated.

In FIG. 5, all transistors included in the pixel circuit PXC are n-type transistors, but are not limited thereto. For example, at least one of the first, second, and third transistors M1, M2, and M3 may be changed to a p-type transistor.

In addition, a structure and a driving method of the pixel PXL may be variously changed. For example, the pixel circuit PXC may be configured of a pixel circuit of various structures and/or driving methods, in addition to the embodiment shown in FIG. 5.

For example, the pixel circuit PXC may not include the third transistor M3. In addition, the pixel circuit PXC may further include other circuit elements such as a compensation transistor for compensating for the threshold voltage or the like of the first transistor M1, an initialization transistor for initializing the voltage of the first node N1 and/or the first electrode ELT1, an emission control transistor for controlling a period in which the driving current is supplied to the light emitting unit EMU, a boosting capacitor for boosting the voltage of the first node N1, and/or the like.

The light emitting unit EMU may include at least one light emitting element LD, for example, a plurality of light emitting elements LD, connected between the first power VDD and second power VSS.

For example, the light emitting unit EMU may include the first connection electrode ELT1 connected to the first power VDD through the pixel circuit PXC and a first power line PL1, a fifth connection electrode ELT5 connected to the second power VSS through a second power line PL2, and the plurality of light emitting elements LD connected between the first and fifth connection electrodes ELT1 and ELT5.

The first power VDD and the second power VSS may have different potentials so that the light emitting elements LD may emit light. For example, the first power VDD may be set as high potential power, and the second power VSS may be set as low potential power.

In one or more embodiments, the light emitting unit EMU may include at least one series stage. Each series stage may include a pair of electrodes (for example, two electrodes) and at least one light emitting element LD connected in a forward direction between the pair of electrodes. Here, the number of series stages configuring the light emitting unit EMU and the number of light emitting elements LD configuring each series stage are not particularly limited. For example, the number of light emitting elements LD configuring each series stage may be identical to or different from each other, and the number of the light emitting elements LD is not particularly limited.

For example, the light emitting unit EMU may include a first series stage including at least one first light emitting element LD1, a second series stage including at least one second light emitting element LD2, a third series stage including at least one third light emitting element LD3, and a fourth series stage including at least one fourth light emitting element LD4.

The first series stage may include the first connection electrode ELT1, a second connection electrode ELT2, and at least one first light emitting element LD1 connected between the first and second connection electrodes ELT1 and ELT2. Each first light emitting element LD1 may be connected in a forward direction between the first and second connection electrodes ELT1 and ELT2. For example, the first end EP1 of the first light emitting element LD1 may be connected to the first connection electrode ELT1, and the second end EP2 of the first light emitting element LD1 may be connected to the second connection electrode ELT2.

The second series stage may include the second connection electrode ELT2, a third connection electrode ELT3, and at least one second light emitting element LD2 connected between the second and third connection electrodes ELT2 and ELT3. Each second light emitting element LD2 may be connected in the forward direction between the second and third connection electrodes ELT2 and ELT3. For example, the first end EP1 of the second light emitting element LD2 may be connected to the second connection electrode ELT2, and the second end EP2 of the second light emitting element LD2 may be connected to the third connection electrode ELT3.

The third series stage may include the third connection electrode ELT3, a fourth connection electrode ELT4, and at least one third light emitting element LD3 connected between the third and fourth connection electrodes ELT3 and ELT4. Each third light emitting element LD3 may be connected in the forward direction between the third and fourth connection electrodes ELT3 and ELT4. For example, the first end EP1 of the third light emitting element LD3 may be connected to the third connection electrode ELT3, and the second end EP2 of the third light emitting element LD3 may be connected to the fourth connection electrode ELT4.

The fourth series stage may include the fourth connection electrode ELT4, the fifth connection electrode ELT5, and at least one fourth light emitting element LD4 connected between the fourth and fifth connection electrodes ELT4 and ELT5. Each fourth light emitting element LD4 may be connected in the forward direction between the fourth and fifth connection electrodes ELT4 and ELT5. For example, the first end EP1 of the fourth light emitting element LD4 may be connected to the fourth connection electrode ELT4, and the second end EP2 of the fourth light emitting element LD4 may be connected to the fifth connection electrode ELT5.

A first electrode of the light emitting unit EMU, for example, the first connection electrode ELT1 may be an anode electrode of the light emitting unit EMU. A last electrode of the light emitting unit EMU, for example, the fifth connection electrode ELT5, may be a cathode electrode of the light emitting unit EMU.

A remaining electrode of the light emitting unit EMU, for example, the second connection electrode ELT2, the third connection electrode ELT3, and/or the fourth connection electrode ELT4 may configure each intermediate electrode. For example, the second connection electrode ELT2 may configure a first intermediate electrode IET1, the third connection electrode ELT3 may configure a second intermediate electrode IET2, and the fourth connection electrode ELT4 may configure a third intermediate electrode IET3.

When the light emitting elements LD are connected in a series/parallel structure, power efficiency may be improved compared to a case where the same number of light emitting elements LD are connected only in parallel. In addition, in the pixel PXL in which the light emitting elements LD are connected in the series/parallel structure, because a desired luminance (e.g., a predetermined luminance) may be expressed through the light emitting elements LD of a remaining series stage even though a short defect or the like occurs at a partial series stage, a possibility of a dark spot defect of the pixel PXL may be reduced. However, the present disclosure is not limited thereto, and the light emitting unit EMU may be configured by connecting the light emitting elements LD only in series, or the light emitting unit EMU may be configured by connecting the light emitting elements LD only in parallel.

Each of the light emitting elements LD may include the first end EP1 (for example, a p-type end) connected to the first power VDD via at least one electrode (for example, the first connection electrode ELT1), the pixel circuit PXC, the first power line PL1, and/or the like, and the second end EP2 (for example, an n-type end) connected to the second power VSS via at least another electrode (for example, the fifth connection electrode ELT5), the second power line PL2, and the like. That is, the light emitting elements LD may be connected in the forward direction between the first power VDD and the second power VSS. The light emitting elements LD connected in the forward direction may configure effective light sources of the light emitting unit EMU.

When the driving current is supplied through the corresponding pixel circuit PXC, the light emitting elements LD may emit light with a luminance corresponding to the driving current. For example, during each frame period, the pixel circuit PXC may supply the driving current corresponding to a grayscale value to be expressed in the corresponding frame to the light emitting unit EMU. Accordingly, while the light emitting elements LD emit light with the luminance corresponding to the driving current, the light emitting unit EMU may express the luminance corresponding to the driving current.

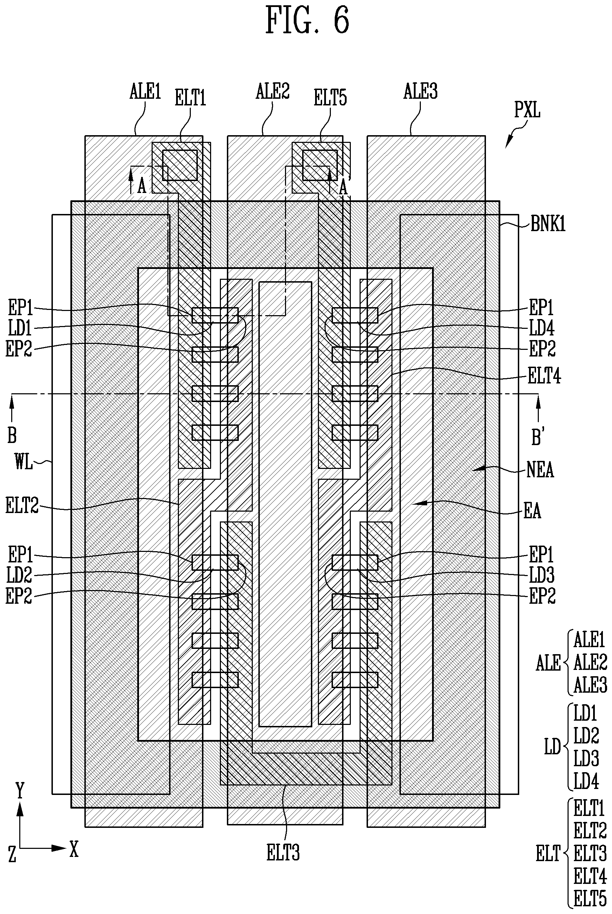

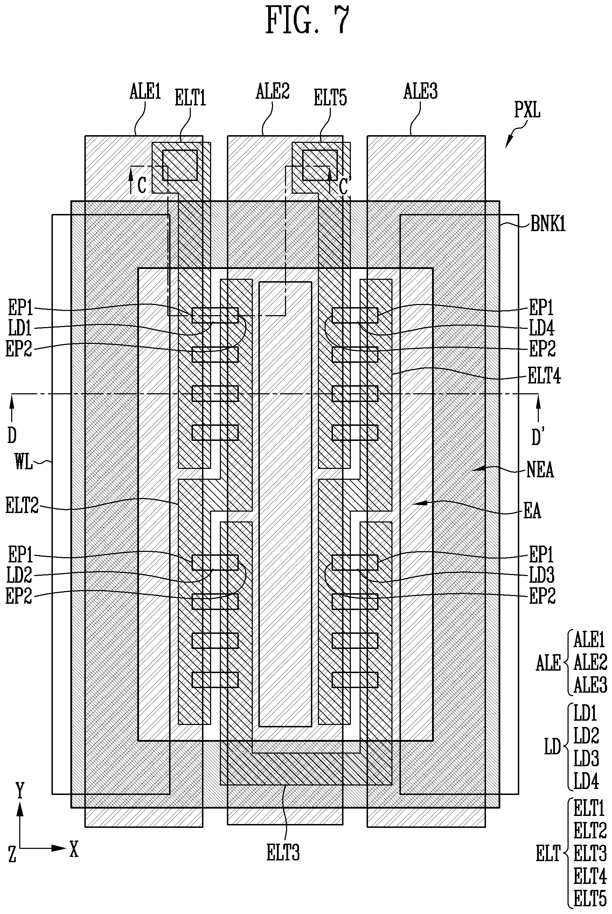

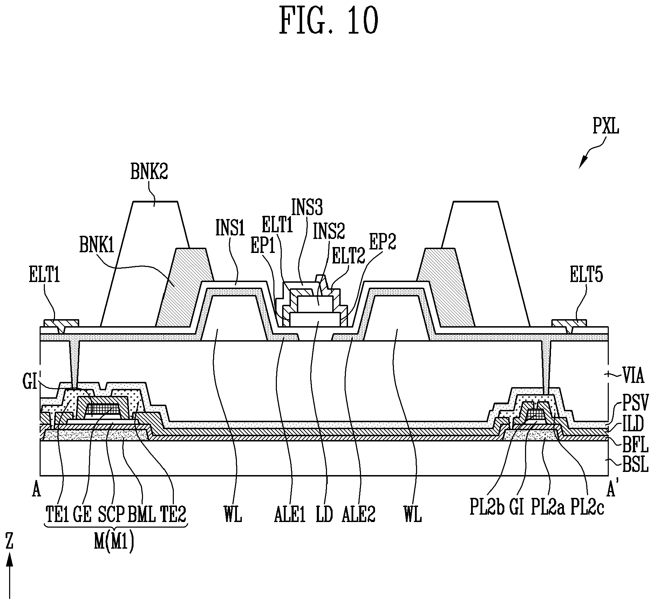

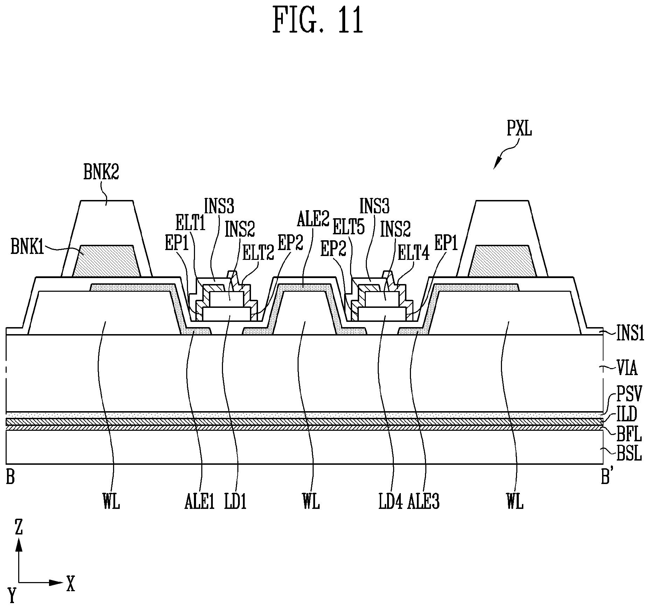

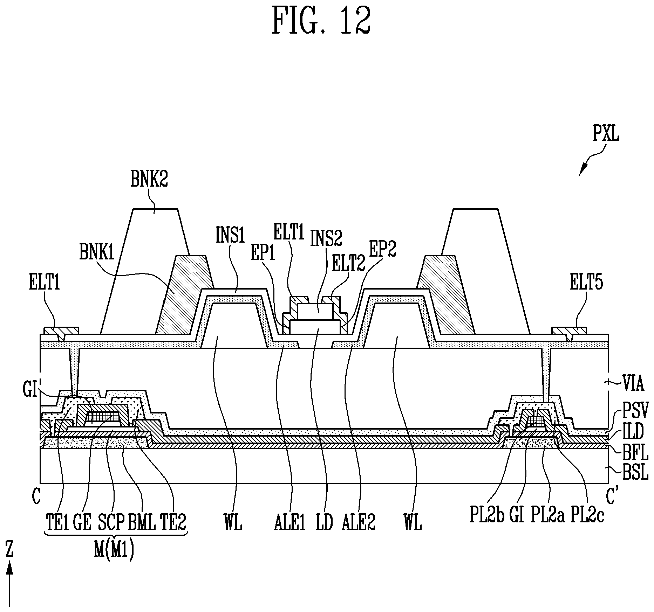

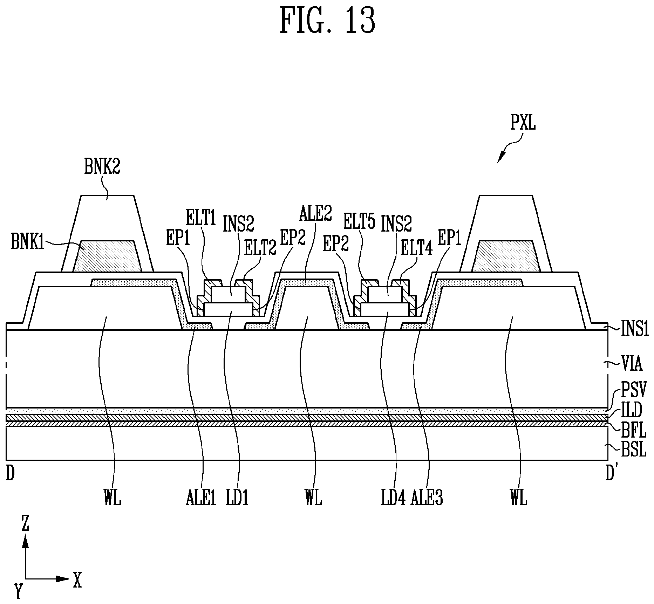

FIGS. 6 and 7 are plan views illustrating a pixel according to one or more embodiments. FIG. 8 is a plan view illustrating a first test transistor according to one or more embodiments. FIG. 9 is a plan view illustrating a second test transistor according to one or more embodiments. FIG. 10 is a cross-sectional view taken along the line A-A' of FIG. 6. FIG. 11 is a cross-sectional view taken along the line B-B' of FIG. 6. FIG. 12 is a cross-sectional view taken along the line C-C' of FIG. 7. FIG. 13 is a cross-sectional view taken along the line D-D' of FIG. 7.

As an example, FIGS. 6 and 7 may be any one of the first to third pixels PXL1, PXL2, and PXL3 configuring the pixel unit PXU of FIG. 3, and the first to third pixels PXL1, PXL2, and PXL3 may have structures substantially identical or similar to each other. In addition, FIGS. 6 and 7 disclose an embodiment in which each pixel PXL includes light emitting elements LD disposed in four series stages as shown in FIG. 5, but the number of series stages of each pixel PXL may be variously changed according to one or more embodiments.

Hereinafter, when one or more of the first to fourth light emitting elements LD1, LD2, LD3, and LD4 are arbitrarily referred to, or when two or more types of light emitting elements are collectively referred to, the one or more of the first to fourth light emitting elements LD1, LD2, LD3, and LD4 or the two or more types of light emitting elements are referred to as a "light emitting element LD" or "light emitting elements LD". In addition, when at least one of electrodes including first to third electrodes ALE1, ALE2, and ALE3 is arbitrarily referred to, the at least one of electrodes is referred to as an "electrode ALE" or "electrodes ALE", and when at least one of electrodes including the first to fifth connection electrodes ELT1, ELT2, ELT3, ELT4, and ELT5 is arbitrarily referred to, the at least one of connection electrodes is referred to as a "connection electrode ELT" or "connection electrodes ELT".

Referring to FIGS. 6 and 7, each pixel PXL may include an emission area EA and a non-emission area NEA. The emission area EA may be an area capable of emitting light including the light emitting elements LD. The non-emission area NEA may be disposed to be around (e.g., to surround) the emission area EA. The non-emission area NEA may be an area in which a first bank BNK1 surrounding the emission area EA is provided. The first bank BNK1 may be provided in the non-emission area NEA to at least partially surround the emission area EA.

The first bank BNK1 may include an opening overlapping the emission area EA. The opening of the first bank BNK1 may provide a space in which the light emitting elements LD may be provided in a step of supplying the light emitting elements LD to each of the pixels PXL. For example, a desired type and/or amount of light emitting element ink may be supplied to a space partitioned by the opening of the first bank BNK1.

The first bank BNK1 may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the first bank BNK1 may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

According to one or more embodiments, the first bank BNK1 may include at least one light blocking and/or reflective material. Accordingly, light leakage between adjacent pixels PXL may be prevented. For example, the first bank BNK1 may include at least one black pigment.

Each pixel PXL may include partition walls WL, the electrodes ALE, the light emitting elements LD, and/or the connection electrodes ELT.

The partition walls WL may overlap the emission area EA and may be spaced from each other. The partition walls WL may be at least partially disposed in the non-emission area NEA. The partition walls WL may extend along the second direction (Y-axis direction) and may be spaced from each other along the first direction (X-axis direction).

Each of the partition walls WL may partially overlap at least one electrode ALE in at least the emission area EA. For example, each of the partition walls WL may be provided under the electrodes ALE. As the partition walls WL are provided under one area of each of the electrodes ALE, one area of each of the electrodes ALE may be protruded in an upper direction of the pixel PXL, that is, a third direction (Z-axis direction) in an area in which the partition walls WL are formed. When the partition walls WL and/or the electrodes ALE include a reflective material, a reflective wall structure may be formed around the light emitting elements LD. Accordingly, because light emitted from the light emitting elements LD may be emitted to an upper direction of the pixel PXL (for example, in a front surface direction of the display panel PNL including a suitable viewing angle range (e.g., a predetermined viewing angle range)), light output efficiency of the display panel PNL may be improved.

The electrodes ALE may be provided in at least the emission area EA. The electrodes ALE may extend along the second direction (Y-axis direction) and may be spaced from each other along the first direction (X-axis direction).

Each of the first to third electrodes ALE1, ALE2, and ALE3 may extend along the second direction (Y-axis direction), and may be sequentially disposed to be spaced from each other along the first direction (X-axis direction). Some of the electrodes ALE may be connected to the pixel circuit PXC of FIG. 5 and/or a suitable power line (e.g., a predetermined power line) through a contact hole. For example, a first electrode ALE1 may be connected to the pixel circuit PXC and/or the first power line PL1 through a corresponding contact hole, and a second electrode ALE2 may be connected to the second power line PL2 through a corresponding contact hole.

According to one or more embodiments, some of the electrodes ALE may be electrically connected to some of the connection electrodes ELT through corresponding contact holes. For example, the first electrode ALE1 may be electrically connected to the first connection electrode ELT1 through a corresponding contact hole, and the second electrode ALE2 may be electrically connected to the fifth connection electrode ELT5 through a corresponding contact hole.

A pair of electrodes ALE adjacent to each other may receive different signals in an alignment step of the light emitting elements LD. For example, when the first to third electrodes ALE1, ALE2, and ALE3 are sequentially arranged along the first direction (X-axis direction), the first electrode ALE1 and the second electrode ALE2 may receive different alignment signals, and the second electrode ALE2 and the third electrode ALE3 may receive different alignment signals.

According to one or more embodiments, the electrodes ALE may at least partially extend to the test area TA (e.g., see FIG. 4). For example, the electrodes ALE may extend to the test area TA to be connected to the test transistors TTR1 and TTR2 (e.g., see FIG. 4). A detailed description thereof is described later with reference to FIGS. 8 and 9.

Each of the light emitting elements LD may be aligned between a pair of electrodes ALE in the emission area EA. In addition, each of the light emitting elements LD may be electrically connected between a pair of connection electrodes ELT.

The first light emitting element LD1 may be aligned between the first and second electrodes ALE1 and ALE2. The first light emitting element LD1 may be electrically connected between the first and second connection electrodes ELT1 and ELT2. For example, the first light emitting element LD1 may be aligned in a first area (for example, an upper area) of the first and second electrodes ALE1 and ALE2, the first end EP1 of the first light emitting element LD1 may be electrically connected to the first connection electrode ELT1, and the second end EP2 of the first light emitting element LD1 may be electrically connected to the second connection electrode ELT2.

The second light emitting element LD2 may be aligned between the first and second electrodes ALE1 and ALE2. The second light emitting element LD2 may be electrically connected between the second and third connection electrodes ELT2 and ELT3. For example, the second light emitting element LD2 may be aligned in a second area (for example, a lower area) of the first and second electrodes ALE1 and ALE2, the first end EP1 of the second light emitting element LD2 may be electrically connected to the second connection electrode ELT2, and the second end EP2 of the second light emitting element LD2 may be electrically connected to the third connection electrode ELT3.

The third light emitting element LD3 may be aligned between the second and third electrodes ALE2 and ALE3. The third light emitting element LD3 may be electrically connected between the third and fourth connection electrodes ELT3 and ELT4. For example, the third light emitting element LD3 may be aligned in a second area (for example, a lower area) of the second and third electrodes ALE2 and ALE3, the first end EP1 of the third light emitting element LD3 may be electrically connected to the third connection electrode ELT3, and the second end EP2 of the third light emitting element LD3 may be electrically connected to the fourth connection electrode ELT4.

The fourth light emitting element LD4 may be aligned between the second and third electrodes ALE2 and ALE3. The fourth light emitting element LD4 may be electrically connected between the fourth and fifth connection electrodes ELT4 and ELT5. For example, the fourth light emitting element LD4 may be aligned in a first area (for example, an upper area) of the second and third electrodes ALE2 and ALE3, the first end EP1 of the fourth light emitting element LD4 may be electrically connected to the fourth connection electrode ELT4, and the second end EP2 of the fourth light emitting element LD4 may be electrically connected to the fifth connection electrode ELT5.

For example, the first light emitting element LD1 may be positioned in an upper left area of the emission area EA, and the second light emitting element LD2 may be positioned in a lower left area of the emission area EA. The third light emitting element LD3 may be positioned in a lower right area of the emission area EA, and the fourth light emitting element LD4 may be positioned in an upper right area of the emission area EA. However, an arrangement, a connection structure, and/or the like of the light emitting elements LD may be variously changed according to a structure of the light emitting unit EMU, the number of series stages, and the like.

Each of the connection electrodes ELT may be provided in at least the emission area EA and may be disposed to overlap at least one electrode ALE and/or the light emitting element LD. For example, each of the connection electrodes ELT may be formed on the electrodes ALE and/or the light emitting elements LD to overlap the electrodes ALE and/or the light emitting elements LD, and may be electrically connected to the light emitting elements LD.

The first connection electrode ELT1 may be disposed in a first area (for example, an upper area) of the first electrode ALE1 and on the first ends EP1 of the first light emitting elements LD1, and may be electrically connected to the first ends EP1 of the first light emitting elements LD1.

The second connection electrode ELT2 may be disposed in a first area (for example, an upper area) of the second electrode ALE2 and on the second ends EP2 of the first light emitting elements LD1, and may be electrically connected to the second ends EP2 of the first light emitting elements LD1. In addition, the second connection electrode ELT2 may be disposed in a second area (for example, a lower area) of the first electrode ALE1 and on the first ends EP1 of the second light emitting elements LD2, and may be electrically connected to the first ends EP1 of the second light emitting elements LD2. For example, the second connection electrode ELT2 may electrically connect the second ends EP2 of the first light emitting elements LD1 and the first ends EP1 of the second light emitting elements LD2 in the emission area EA. To this end, the second connection electrode ELT2 may have a curved shape. For example, the second connection electrode ELT2 may have a bent or curved structure at a boundary between an area in which at least one first light emitting element LD1 is arranged and an area in which at least one second light emitting element LD2 is arranged.

The third connection electrode ELT3 may be disposed in a second area (for example, a lower area) of the second electrode ALE2 and on the second ends EP2 of the second light emitting elements LD2, and may be electrically connected to the second ends EP2 of the second light emitting elements LD2. In addition, the third connection electrode ELT3 may be disposed in a second area (for example, a lower area) of the third electrode ALE3 and on the first ends EP1 of the third light emitting elements LD3, and may be electrically connected to the first ends EP1 of the third light emitting elements LD3. For example, the third connection electrode ELT3 may electrically connect the second ends EP2 of the second light emitting elements LD2 and the first ends EP1 of the third light emitting elements LD3 in the emission area EA. To this end, the third connection electrode ELT3 may have a curved shape. For example, the third connection electrode ELT3 may have a bent or curved structure at a boundary between an area in which at least one second light emitting element LD2 is arranged and an area in which at least one third light emitting element LD3 is arranged.

The fourth connection electrode ELT4 may be disposed in a second area (for example, a lower area) of the second electrode ALE2 and on the second ends EP2 of the third light emitting elements LD3, and may be electrically connected to the second ends EP2 of the third light emitting elements LD3. In addition, the fourth connection electrode ELT4 may be disposed in a first area (for example, an upper area) of the third electrode ALE3 and on the first ends EP1 of the fourth light emitting elements LD4, and may be electrically connected to the first ends EP1 of the fourth light emitting elements LD4. For example, the fourth connection electrode ELT4 may electrically connect the second ends EP2 of the third light emitting elements LD3 and the first ends EP1 of the fourth light emitting elements LD4 in the emission area EA. To this end, the fourth connection electrode ELT4 may have a curved shape. For example, the fourth connection electrode ELT4 has a bent or curved structure at a boundary between an area in which at least one third light emitting element LD3 is arranged and an area in which at least one fourth light emitting element LD4 is arranged.

The fifth connection electrode ELT5 may be disposed in a first area (for example, an upper area) of the second electrode ALE2 and on the second ends EP2 of the fourth light emitting elements LD4, and may be electrically connected to the second ends EP2 of the fourth light emitting elements LD4.

The first connection electrode ELT1, the third connection electrode ELT3, and/or the fifth connection electrode ELT5 may be formed of the same conductive layer. In addition, the second connection electrode ELT2 and the fourth connection electrode ELT4 may be formed of the same conductive layer. For example, as shown in FIG. 6, the connection electrodes ELT may be formed of a plurality of conductive layers. That is, the first connection electrode ELT1, the third connection electrode ELT3, and/or the fifth connection electrode ELT5 may be formed of a first conductive layer, and the second connection electrode ELT2 and the fourth connection electrode ELT4 may be formed of a second conductive layer different from the first conductive layer. Alternatively, as shown in FIG. 7, the first to fifth connection electrodes ELT1, ELT2, ELT3, ELT4, and ELT5 may be formed of the same conductive layer.

In the embodiment of FIGS. 6-7, the light emitting elements LD aligned between the electrodes ALE may be connected in a desired shape using the connection electrodes ELT. For example, the first light emitting elements LD1, the second light emitting elements LD2, the third light emitting elements LD3, and the fourth light emitting elements LD4 may be connected in series sequentially using the connection electrodes ELT.

Referring to FIG. 8, the first test transistor TTR1 may include a test gate electrode TGE, a test semiconductor pattern TSCP, a first test transistor electrode TTE1, and/or a second test transistor electrode TTE2. The test gate electrode TGE of the first test transistor TTR1 may be connected to the above-described test line TL. For example, the test gate electrode TGE of the first test transistor TTR1 may contact the test line TL through a contact hole.

One area of the first test transistor electrode TTE1 of the first test transistor TTR1 may be connected to one area of the test semiconductor pattern TSCP. For example, one area of the first test transistor electrode TTE1 of the first test transistor TTR1 may contact one area of the test semiconductor pattern TSCP through a contact hole. An other area of the first test transistor electrode TTE1 of the first test transistor TTR1 may be connected to the above-described first test electrode TEL1 and/or third test electrode TEL3. For example, the other area of the first test transistor electrode TTE1 of the first test transistor TTR1 may contact the first test electrode TEL1 and/or the third test electrode TEL3 through a contact hole.

One area of the second test transistor electrode TTE2 of the first test transistor TTR1 may be connected to another area of the test semiconductor pattern TSCP. For example, one area of the second test transistor electrode TTE2 of the first test transistor TTR1 may contact the other area of the test semiconductor pattern TSCP through a contact hole. Another area of the second test transistor electrode TTE2 of the first test transistor TTR1 may be connected to the above-described electrodes ALE. For example, the other area of the second test transistor electrode TTE2 of the first test transistor TTR1 may contact the electrodes ALE through a contact hole.

According to one or more embodiments, the electrodes ALE, the first test electrode TEL1, and/or the third test electrode TEL3 may be formed of the same conductive layer, but are/is not limited thereto. In addition, the test line TL, the first test transistor electrode TTE1 of the first test transistor TTR1, and/or the second test transistor electrode TTE2 may be formed of the same conductive layer, but are/is not limited thereto.

Referring to FIG. 9, the second test transistor TTR2 may include a test gate electrode TGE, a test semiconductor pattern TSCP, a first test transistor electrode TTE1, and/or a second test transistor electrode TTE2. The test gate electrode TGE of the second test transistor TTR2 may be connected to the above-described test line TL. For example, the test gate electrode TGE of the second test transistor TTR2 may contact the test line TL through a contact hole.

One area of the first test transistor electrode TTE1 of the second test transistor TTR2 may be connected to one area of the test semiconductor pattern TSCP. For example, one area of the first test transistor electrode TTE1 of the second test transistor TTR2 may contact one area of the test semiconductor pattern TSCP through a contact hole. Another area of the first test transistor electrode TTE1 of the second test transistor TTR2 may be connected to the above-described second test electrode TEL2. For example, the other area of the first test transistor electrode TTE1 of the second test transistor TTR2 may contact the second test electrode TEL2 through a contact hole.

One area of the second test transistor electrode TTE2 of the second test transistor TTR2 may be connected to another area of the test semiconductor pattern TSCP. For example, one area of the second test transistor electrode TTE2 of the second test transistor TTR2 may contact the other area of the test semiconductor pattern TSCP through a contact hole. Another area of the second test transistor electrode TTE2 of the second test transistor TTR2 may be connected to the above-described electrodes ALE. For example, the other area of the second test transistor electrode TTE2 of the second test transistor TTR2 may contact the electrodes ALE through a contact hole.

According to one or more embodiments, the electrodes ALE and the second test electrode TEL2 may be formed of the same conductive layer, but are not limited thereto. In addition, the test line TL, the first test transistor electrode TTE1 of the second test transistor TTR2, and/or the second test transistor electrode TTE2 may be formed of the same conductive layer, but are/is not limited thereto.

Hereinafter, a cross-sectional structure of the pixel PXL is described in detail with reference to FIGS. 10 to 13. FIGS. 10 and 12 show the first transistor M1 from among various circuit elements configuring the pixel circuit PXC of FIG. 5, when the first to third transistors M1, M2, and M3 are not required to be separately specified, the first to third transistors M1, M2, and M3 are collectively referred to as "transistor M". In one or more embodiments, a structure, a position of each layer, and/or the like of the transistors M are/is not limited to the embodiment shown in FIGS. 10 and 12, and may be variously changed according to one or more embodiments.

The pixels PXL according to one or more embodiments may include circuit element including the transistors M disposed on a base layer BSL, and various lines connected to the circuit elements. The electrodes ALE, the light emitting elements LD, the connection electrodes ELT, the first bank BNK1, and/or a second bank BNK2 configuring the light emitting unit EMU may be disposed on the circuit elements.

The base layer BSL may configure a base member, and may be a rigid or flexible substrate or film. For example, the base layer BSL may be a rigid substrate formed of glass or tempered glass, a flexible substrate (or thin film) of a plastic or metal material, or an insulating layer of at least one layer. A material and/or a physical property of the base layer BSL are/is not particularly limited. In one or more embodiments, the base layer BSL may be substantially transparent. Here, "substantially transparent" may mean that light may be transmitted at a desired transmittance (e.g., a predetermined transmittance) or more. In one or more embodiments, the base layer BSL may be translucent or opaque. In addition, the base layer BSL may include a reflective material according to one or more embodiments.

The lower conductive layer BML and a first power conductive layer PL2a may be disposed on the base layer BSL. The lower conductive layer BML and the first power conductive layer PL2a may be disposed in the same layer. For example, the lower conductive layer BML and the first power conductive layer PL2a may be concurrently (e.g., simultaneously) formed in the same process, but are not limited thereto. The first power conductive layer PL2a may configure the second power line PL2 described with reference to FIG. 5 or the like.

Each of the lower conductive layer BML and the first power conductive layer PL2a may be formed as a single layer or multiple layers formed of molybdenum (Mo), copper (Cu), aluminum (Al), chromium (Cr), gold (Au), titanium (Ti), nickel (Ni), neodymium (Nd), indium (In), tin (Sn), and an oxide or an alloy thereof.

A buffer layer BFL may be disposed on the lower conductive layer BML, the first power conductive layer PL2a, and the base layer BSL. The buffer layer BFL may prevent an impurity from being diffused into the circuit element. The buffer layer BFL may be configured as a single layer, but may be configured as multiple layers of at least two or more layers. When the buffer layer BFL is formed of multiple layers, each layer may be formed of the same material or may be formed of different materials.

A semiconductor pattern SCP may be disposed on the buffer layer BFL. For example, each semiconductor pattern SCP may include a first area that is in contact with a first transistor electrode TE1, a second area that is in contact with a second transistor electrode TE2, and a channel area positioned between the first and second areas. According to one or more embodiments, one of the first and second areas may be a source area and the other may be a drain area.

According to one or more embodiments, the semiconductor pattern SCP may be formed of polysilicon, amorphous silicon, oxide semiconductor, or the like. In addition, the channel area of the semiconductor pattern SCP may be an intrinsic semiconductor as a semiconductor pattern that is not doped with an impurity, and each of the first and second areas of the semiconductor pattern SCP may be a semiconductor doped with a suitable impurity (e.g., a predetermined impurity).

A gate insulating layer GI may be disposed on the buffer layer BFL and the semiconductor pattern SCP. For example, the gate insulating layer GI may be disposed between the semiconductor pattern SCP and a gate electrode GE. In addition, the gate insulating layer GI may be disposed between the buffer layer BFL and a second power conductive layer PL2b. The gate insulating layer GI may be configured as a single layer or multiple layers, and may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The gate electrode GE of the transistor M and the second power conductive layer PL2b may be disposed on the gate insulating layer GI. The gate electrode GE and the second power conductive layer PL2b may be disposed in the same layer. For example, the gate electrode GE and the second power conductive layer PL2b may be concurrently (e.g., simultaneously) formed in the same process, but are not limited thereto. The gate electrode GE may be disposed to overlap the semiconductor pattern SCP in the third direction (Z-axis direction) on the gate insulating layer GI. The second power conductive layer PL2b may be disposed to overlap the first power conductive layer PL2a in the third direction (Z-axis direction) on the gate insulating layer GI. The second power conductive layer PL2b may configure the second power line PL2 described with reference to FIG. 5 or the like together with the first power conductive layer PL2a.

Each of the gate electrode GE and the second power conductive layer PL2b may be formed as a single layer or multiple layers formed of molybdenum (Mo), copper (Cu), aluminum (Al), chromium (Cr), gold (Au), titanium (Ti), nickel (Ni), neodymium (Nd), indium (In), tin (Sn), and an oxide or an alloy thereof. For example, each of the gate electrode GE and the second power conductive layer PL2b may be formed as multiple layers in which titanium (Ti), copper (Cu), and/or indium tin oxide (ITO) are/is sequentially or repeatedly stacked.

An interlayer insulating layer ILD may be disposed on the gate electrode GE, the second power conductive layer PL2b, and the buffer layer BFL. For example, the interlayer insulating layer ILD may be disposed between the gate electrode GE and the first and second transistor electrodes TE1 and TE2. In addition, the interlayer insulating layer ILD may be disposed between the second power conductive layer PL2b and a third power conductive layer PL2c.

The interlayer insulating layer ILD may be configured as a single layer or multiple layers, and may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The first and second transistor electrodes TE1 and TE2 of the transistor M and the third power conductive layer PL2c may be disposed on the interlayer insulating layer ILD. The first and second transistor electrodes TE1 and TE2 and the third power conductive layer PL2c may be disposed in the same layer. For example, the first and second transistor electrodes TE1 and TE2 and the third power conductive layer PL2c may be concurrently (e.g., simultaneously) formed in the same process, but are not limited thereto.

The first and second transistor electrodes TE1 and TE2 may be disposed to overlap the semiconductor pattern SCP in the third direction (Z-axis direction). The first and second transistor electrodes TE1 and TE2 may be electrically connected to the semiconductor pattern SCP. For example, the first transistor electrode TE1 may be electrically connected to the first area of the semiconductor pattern SCP through a contact hole passing through the interlayer insulating layer ILD. In addition, the first transistor electrode TE1 may be electrically connected to the lower conductive layer BML through a contact hole passing through the interlayer insulating layer ILD and the buffer layer BFL. The second transistor electrode TE2 may be electrically connected to the second area of the semiconductor pattern SCP through a contact hole passing through the interlayer insulating layer ILD. According to one or more embodiments, any one of the first and second transistor electrodes TE1 and TE2 may be a source electrode, and the other may be a drain electrode.

The third power conductive layer PL2c may be disposed to overlap the first power conductive layer PL2a and/or the second power conductive layer PL2b in the third direction (Z-axis direction). The third power conductive layer PL2c may be electrically connected to the first power conductive layer PL2a and/or the second power conductive layer PL2b. For example, the third power conductive layer PL2c may be electrically connected to the first power conductive layer PL2a through a contact hole passing through the interlayer insulating layer ILD and the buffer layer BFL. In addition, the third power conductive layer PL2c may be electrically connected to the second power conductive layer PL2b through a contact hole passing through the interlayer insulating layer ILD. The third power conductive layer PL2c may configure the second power line PL2 described with reference to FIG. 5 or the like together with the first power conductive layer PL2a and/or the second power conductive layer PL2b.

The first and second transistor electrodes TE1 and TE2 and the third power conductive layer PL2c may be formed as a single layer or multiple layers formed of molybdenum (Mo), copper (Cu), aluminum (Al), chromium (Cr), gold (Au), titanium (Ti), nickel (Ni), neodymium (Nd), indium (In), tin (Sn), and an oxide or an alloy thereof.

A protective layer PSV may be disposed on the first and second transistor electrodes TE1 and TE2 and the third power conductive layer PL2c. The protective layer PSV may be configured as a single layer or multiple layers, and may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The via layer VIA may be disposed on the protective layer PSV. The via layer VIA may be formed of an organic material to planarize a lower step difference. For example, the via layer VIA may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the via layer VIA may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The partition walls WL may be disposed on the via layer VIA. The partition walls WL may serve to form a suitable step difference (e.g., a predetermined step difference) so that the light emitting elements LD may be easily aligned in the emission area EA.

The partition walls WL may have various shapes according to one or more embodiments. In one or more embodiments, the partition walls WL may have a shape protruding in the third direction (Z-axis direction) on the base layer BSL. In addition, the partition walls WL may be formed to have an inclined surface inclined at a suitable angle (e.g., a predetermined angle) with respect to the base layer BSL. However, the present disclosure is not limited thereto, and the partition walls WL may have a side wall of a curved surface, a step shape, or the like. For example, the partition walls WL may have a cross-section of a semi-circle shape, a semi-ellipse shape, or the like.

The partition walls WL may include at least one organic material and/or inorganic material. For example, the partition walls WL may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the partition walls WL may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The electrodes ALE may be disposed on the via layer VIA and the partition walls WL. The electrodes ALE may at least partially cover a side surface and/or an upper surface of the partition walls WL. The electrodes ALE disposed on the partition walls WL may have a shape corresponding to the partition wall WL. For example, the electrodes ALE disposed on the partition walls WL may include an inclined surface or a curved surface having a shape corresponding to a shape of the partition walls WL. In this case, because the partition walls WL and the electrodes ALE may reflect the light emitted from the light emitting elements LD and guide the light in a front direction of the pixel PXL, that is, in the third direction (Z-axis direction) as a reflective member, the light output efficiency of the display panel PNL may be improved.

The electrodes ALE may be disposed to be spaced from each other. The electrodes ALE may be disposed in the same layer. For example, the electrodes ALE may be concurrently (e.g., simultaneously) formed in the same process, but the present disclosure is not limited thereto.

The electrodes ALE may receive an alignment signal in an alignment step of the light emitting elements LD. Accordingly, an electric field may be formed between the electrodes ALE, and thus the light emitting elements LD provided to each of the pixels PXL may be aligned between the electrodes ALE.

The electrodes ALE may include at least one conductive material. For example, the electrodes ALE may include at least one metal from among various metal materials including silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), and copper (Cu), or an alloy including the at least one metal, a conductive oxide such as indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and at least one conductive material from among conductive polymers such as PEDOT, but are not limited thereto.

The first electrode ALE1 may be electrically connected to the first transistor electrode TE1 of the transistor M through a contact hole passing through the via layer VIA and the protective layer PSV. The second electrode ALE2 may be electrically connected to the third power conductive layer PL2c through a contact hole passing through the via layer VIA and the protective layer PSV.

A first insulating layer INS1 may be disposed on the electrodes ALE. The first insulating layer INS1 may be configured as a single layer or multiple layers, and may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The first bank BNK1 may be disposed on the first insulating layer INS1. The first bank BNK1 may include the opening overlapping the emission area EA. The opening of the first bank BNK1 may provide the space in which the light emitting elements LD may be provided in the step of supplying the light emitting elements LD to each of the pixels PXL. For example, a desired type and/or amount of light emitting element ink may be supplied to the space partitioned by the opening of the first bank BNK1.

The first bank BNK1 may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the first bank BNK1 may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The light emitting elements LD may be disposed between the electrodes ALE. The light emitting elements LD may be provided in the opening of the first bank BNK1 and may be disposed between the partition walls WL.

The light emitting elements LD may be prepared in a dispersed form in the light emitting element ink, and may be supplied to each of the pixels PXL through an inkjet printing method or the like. For example, the light emitting elements LD may be dispersed in a volatile solvent and may be provided to each of the pixels PXL. Subsequently, when the alignment signal is supplied to the electrodes ALE, an electric field may be formed between the electrodes ALE, and thus the light emitting elements LD may be aligned between the electrodes ALE. After the light emitting elements LD are aligned, the light emitting elements LD may be stably arranged between the electrodes ALE by evaporating the solvent or removing the solvent in another method.

A second insulating layer INS2 may be disposed on the light emitting elements LD. For example, the second insulating layer INS2 may be partially provided on the light emitting elements LD and may expose the first and second ends EP1 and EP2 of the light emitting elements LD. When the second insulating layer INS2 is formed on the light emitting elements LD after alignment of the light emitting elements LD is completed, the light emitting elements LD may be prevented from being separated from an aligned position.

The second insulating layer INS2 may be configured as a single layer or multiple layers, and may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The connection electrodes ELT may be disposed on the first and second ends EP1 and EP2 of the light emitting elements LD exposed by the second insulating layer INS2. The first connection electrode ELT1 may be directly disposed on the first end EP1 of the first light emitting elements LD1 to contact the first end EP1 of the first light emitting elements LD1.

In addition, the second connection electrode ELT2 may be directly disposed on the second end EP2 of the first light emitting elements LD1 to contact the second end EP2 of the first light emitting elements LD1. In addition, the second connection electrode ELT2 may be directly disposed on the first end EP1 of the second light emitting elements LD2 to contact the first end EP1 of the second light emitting elements LD2. That is, the second connection electrode ELT2 may electrically connect the second end EP2 of the first light emitting elements LD1 and the first end EP1 of the second light emitting elements LD2.

Similarly, the third connection electrode ELT3 may be directly disposed on the second end EP2 of the second light emitting elements LD2 to contact the second end EP2 of the second light emitting elements LD2. In addition, the third connection electrode ELT3 may be directly disposed on the first end EP1 of the third light emitting elements LD3 to contact the first end EP1 of the third light emitting elements LD3. That is, the third connection electrode ELT3 may electrically connect the second end EP2 of the second light emitting elements LD2 and the first end EP1 of the third light emitting elements LD3.

Similarly, the fourth connection electrode ELT4 may be directly disposed on the second end EP2 of the third light emitting elements LD3 to contact the second end EP2 of the third light emitting elements LD3. In addition, the fourth connection electrode ELT4 may be directly disposed on the first end EP1 of the fourth light emitting elements LD4 to contact the first end EP1 of the fourth light emitting elements LD4. That is, the fourth connection electrode ELT4 may electrically connect the second end EP2 of the third light emitting elements LD3 and the first end EP1 of the fourth light emitting elements LD4.

Similarly, the fifth connection electrode ELT5 may be directly disposed on the second end EP2 of the fourth light emitting elements LD4 to contact the second end EP2 of the fourth light emitting elements LD4.

The first connection electrode ELT1 may be electrically connected to the first electrode ALE1 through a contact hole passing through the first insulating layer INS1. The fifth connection electrode ELT5 may be electrically connected to the second electrode ALE2 through a contact hole passing through the first insulating layer INS1.

In one or more embodiments, the connection electrodes ELT may be configured of a plurality of conductive layers. For example, as shown in FIGS. 10 and 11, the first connection electrode ELT1, the third connection electrode ELT3, and the fifth connection electrode ELT5 may be disposed in the same layer. In addition, the second connection electrode ELT2 and the fourth connection electrode ELT4 may be disposed in the same layer. The first connection electrode ELT1, the third connection electrode ELT3, and the fifth connection electrode ELT5 may be disposed on the second insulating layer INS2. A third insulating layer INS3 may be disposed on the first connection electrode ELT1, the third connection electrode ELT3, and the fifth connection electrode ELT5. The second connection electrode ELT2 and the fourth connection electrode ELT4 may be disposed on the third insulating layer INS3.

As described above, when the third insulating layer INS3 is disposed between the connection electrodes ELT formed of different conductive layers, because the connection electrodes ELT may be stably separated by the third insulating layer INS3, electrical stability between the first and second ends EP1 and EP2 of the light emitting elements LD may be secured.

The third insulating layer INS3 may be configured as a single layer or multiple layers, and may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

In one or more embodiments, the connection electrodes ELT may be configured of the same conductive layer. For example, as shown in FIGS. 12 and 13, the first to fifth connection electrodes ELT1, ELT2, ELT3, ELT4, and ELT5 may be disposed in the same layer. For example, the first to fifth connection electrodes ELT1, ELT2, ELT3, ELT4, and ELT5 may be concurrently (e.g., simultaneously) formed in the same process. As described above, when the connection electrodes ELT are concurrently (e.g., simultaneously) formed, the number of masks may be reduced and a manufacturing process may be simplified.

The connection electrodes ELT may be formed of various transparent conductive materials. For example, the connection electrodes ELT may include at least one of various transparent conductive materials including indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and may be implemented to be substantially transparent or translucent to satisfy a suitable light transmittance (e.g., a predetermined light transmittance). Accordingly, light emitted from the first and second ends EP1 and EP2 of the light emitting elements LD may pass through the connection electrodes ELT and may be emitted to the outside of the display panel PNL.

The second bank BNK2 may be disposed on the first bank BNK1. The second bank BNK2 may be disposed in the non-emission area NEA.

The second bank BNK2 may include an opening overlapping the emission area EA. The opening of the second bank BNK2 may provide a space in which a color conversion layer to be described later is provided. For example, a desired type and/or amount of the color conversion layer may be supplied to a space partitioned by the opening of the second bank BNK2.

The second bank BNK2 may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the second bank BNK2 may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

According to one or more embodiments, the second bank BNK2 may include at least one light blocking and/or reflective material. Accordingly, light leakage between adjacent pixels PXL may be prevented. For example, the second bank BNK2 may include at least one black pigment.

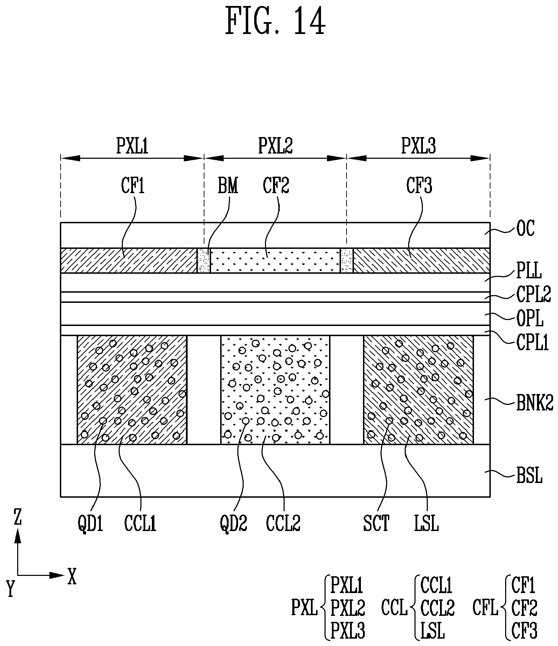

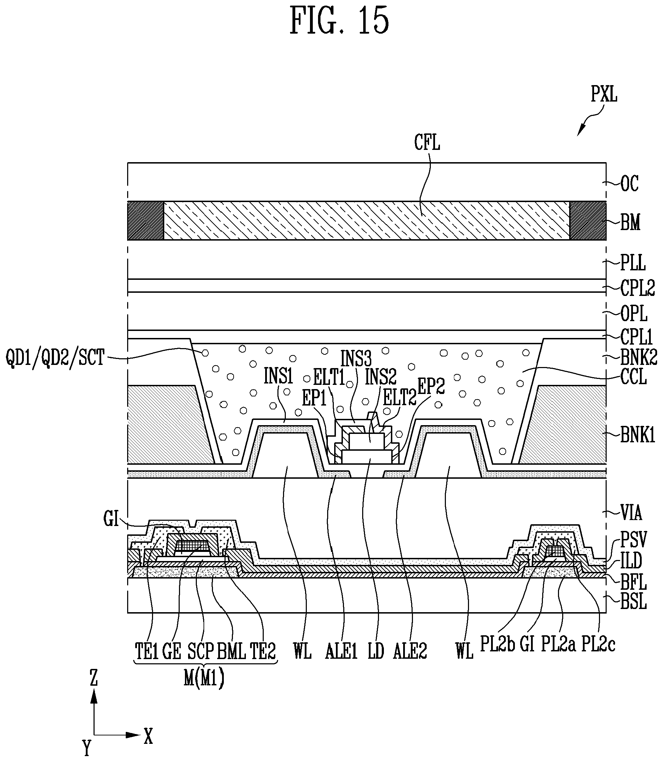

FIG. 14 is a cross-sectional view illustrating first to third pixels according to one or more embodiments. FIG. 15 is a cross-sectional view of a pixel according to one or more embodiments.

FIG. 14 shows a color conversion layer CCL, an optical layer OPL, a color filter layer CFL, and/or the like. In FIG. 14, a configuration except for the base layer BSL and the second bank BNK2 of FIGS. 10 to 13 is omitted for convenience of description. FIG. 15 illustrates a stack structure of the pixel PXL in relation to the color conversion layer CCL, the optical layer OPL, and/or the color filter layer CFL in detail.

Referring to FIGS. 14 and 15, the second bank BNK2 may be disposed between or at a boundary between the first to third pixels PXL1, PXL2, and PXL3, and may include the opening overlapping each of the first to third pixels PXL1, PXL2, and PXL3. The opening of the second bank BNK2 may provide the space in which the color conversion layer CCL may be provided.

The color conversion layer CCL may be disposed on the light emitting elements LD in the opening of the second bank BNK2. The color conversion layer CCL may include a first color conversion layer CCL1 disposed in the first pixel PXL1, a second color conversion layer CCL2 disposed in the second pixel PXL2, and a scattering layer LSL disposed in the third pixel PXL3.

In one or more embodiments, the first to third pixels PXL1, PXL2, and PXL3 may include light emitting elements LD that emit light of the same color. For example, the first to third pixels PXL1, PXL2, and PXL3 may include light emitting elements LD emitting light of a third color (or blue). The color conversion layer CCL including color conversion particles may be disposed on each of the first to third pixels PXL1, PXL2, and PXL3 to display a full-color image.

The first color conversion layer CCL1 may include first color conversion particles that convert light of the third color emitted from the light emitting element LD into light of the first color. For example, the first color conversion layer CCL1 may include a plurality of first quantum dots QD1 dispersed in a suitable matrix material (e.g., a predetermined matrix material) such as a base resin.

In one or more embodiments, when the light emitting element LD is a blue light emitting element emitting blue light and the first pixel PXL1 is a red pixel, the first color conversion layer CCL1 may include a first quantum dot QD1 that converts the blue light emitted from the blue light emitting element into red light. The first quantum dot QD1 may absorb the blue light and shift a wavelength according to an energy transition to emit the red light. In one or more embodiments, when the first pixel PXL1 is a pixel of a different color, the first color conversion layer CCL1 may include a first quantum dot QD1 corresponding to the color of the first pixel PXL1.

The second color conversion layer CCL2 may include second color conversion particles that convert light of the third color emitted from the light emitting element LD into light of the second color. For example, the second color conversion layer CCL2 may include a plurality of second quantum dots QD2 dispersed in a suitable matrix material (e.g., a predetermined matrix material) such as a base resin.

In one or more embodiments, when the light emitting element LD is the blue light emitting element emitting the blue light and the second pixel PXL2 is a green pixel, the second color conversion layer CCL2 may include a second quantum dot QD2 that converts the blue light emitted from the blue light emitting element into green light. The second quantum dot QD2 may absorb the blue light and shift a wavelength according to an energy transition to emit the green light. In one or more embodiments, when the second pixel PXL2 is a pixel of a different color, the second color conversion layer CCL2 may include a second quantum dot QD2 corresponding to the color of the second pixel PXL2.

In one or more embodiments, an absorption coefficient of the first quantum dot QD1 and the second quantum dot QD2 may be increased by allowing the blue light having a relatively short wavelength in a visible light area to be incident on each of the first quantum dot QD1 and the second quantum dot QD2. Accordingly, finally, efficiency of light emitted from the first pixel PXL1 and the second pixel PXL2 may be improved, and excellent color reproducibility may be secured. In addition, manufacturing efficiency of the display device may be increased, by configuring the light emitting unit EMU of the first to third pixels PXL1, PXL2, and PXL3 using the light emitting elements LD of the same color (for example, the blue light emitting element).

The scattering layer LSL may be provided to efficiently use the light of the third color (or blue) emitted from the light emitting element LD. For example, when the light emitting element LD is the blue light emitting element emitting the blue light and the third pixel PXL3 is the blue pixel, the scattering layer LSL may include at least one type of scatterer SCT in order to efficiently use the light emitted from the light emitting element LD. For example, the scatterer SCT of the scattering layer LSL may include at least one of barium sulfate (BaSO₄), calcium carbonate (CaCO₃), titanium oxide (TiO₂), silicon oxide (SiO₂), aluminum oxide (Al₂O₃), zirconium oxide (ZrO₂), and zinc oxide (ZnO). In one or more embodiments, the scatterer SCT may also be disposed in an area in addition to the third pixel PXL3, and may be selectively included in the first color conversion layer CCL1 or the second color conversion layer CCL2. According to one or more embodiments, the scatterer SCT may be omitted and the scattering layer LSL formed of a transparent polymer may be provided.

A first capping layer CPL1 may be disposed on the color conversion layer CCL. The first capping layer CPL1 may be provided over the first to third pixels PXL1, PXL2, and PXL3. The first capping layer CPL1 may cover the color conversion layer CCL. The first capping layer CPL1 may prevent an impurity such as moisture or air from penetrating from the outside and damaging or contaminating the color conversion layer CCL.

The first capping layer CPL1 may be an inorganic layer, and may include silicon nitride (SiNx), aluminum nitride (AlNx), titanium nitride (TiNx), silicon oxide (SiOx), aluminum oxide (AlOx), titanium oxide (TiOx), silicon oxycarbide (SiOxCy), silicon oxynitride (SiOxNy), or the like.

The optical layer OPL may be disposed on the first capping layer CPL1. The optical layer OPL may serve to improve light extraction efficiency by recycling light provided from the color conversion layer CCL by total reflection. To this end, the optical layer OPL may have a relatively low refractive index compared to the color conversion layer CCL. For example, the refractive index of the color conversion layer CCL may be about 1.6 to 2.0, and the refractive index of the optical layer OPL may be about 1.1 to 1.3.

A second capping layer CPL2 may be disposed on the optical layer OPL. The second capping layer CPL2 may be provided over the first to third pixels PXL1, PXL2, and PXL3. The second capping layer CPL2 may cover the optical layer OPL. The second capping layer CPL2 may prevent an impurity such as moisture or air from penetrating from the outside and damaging or contaminating the optical layer OPL.

The second capping layer CPL2 may be an inorganic layer, and may include silicon nitride (SiNx), aluminum nitride (AlNx), titanium nitride (TiNx), silicon oxide (SiOx), aluminum oxide (AlOx), titanium oxide (TiOx), silicon oxycarbide (SiOxCy), silicon oxynitride (SiOxNy), or the like.

A planarization layer PLL may be disposed on the second capping layer CPL2. The planarization layer PLL may be provided over the first to third pixels PXL1, PXL2, and PXL3.

The planarization layer PLL may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the planarization layer PLL may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

The color filter layer CFL may be disposed on the planarization layer PLL. The color filter layer CFL may include color filters CF1, CF2, and CF3 matching the colors of each pixel PXL. As the color filters CF1, CF2, and CF3 matching the colors of each of the first to third pixels PXL1, PXL2, and PXL3 are disposed, the full-color image may be displayed.

The color filter layer CFL may include a first color filter CF1 disposed in the first pixel PXL1 to selectively transmit light emitted from the first pixel PXL1, a second color filter CF2 disposed in the second pixel PXL2 to selectively transmit light emitted from the second pixel PXL2, and a third color filter CF3 disposed in the third pixel PXL3 to selectively transmit light emitted from the third pixel PXL3.

In one or more embodiments, the first color filter CF1, the second color filter CF2, and the third color filter CF3 may be a red color filter, a green color filter, and a blue color filter, respectively, but are not limited thereto. Hereinafter, when any color filter from among the first color filter CF1, the second color filter CF2, and the third color filter CF3 is refer to, or two or more types of color filters are collectively refer to, the any color filter or the two or more types of color filters is referred to as a "color filter CF" or "color filters CF".

The first color filter CF1 may overlap the first color conversion layer CCL1 in the third direction (Z-axis direction). The first color filter CF1 may include a color filter material that selectively transmits the light of the first color (or red). For example, when the first pixel PXL1 is the red pixel, the first color filter CF1 may include a red color filter material.

The second color filter CF2 may overlap the second color conversion layer CCL2 in the third direction (Z-axis direction). The second color filter CF2 may include a color filter material that selectively transmits the light of the second color (or green). For example, when the second pixel PXL2 is the green pixel, the second color filter CF2 may include a green color filter material.

The third color filter CF3 may overlap the scattering layer LSL in the third direction (Z-axis direction). The third color filter CF3 may include a color filter material that selectively transmits the light of the third color (or blue). For example, when the third pixel PXL3 is the blue pixel, the third color filter CF3 may include a blue color filter material.

According to one or more embodiments, a light blocking layer BM may be further disposed between the first to third color filters CF1, CF2, and CF3. As described above, the light blocking layer BM is formed between the first to third color filters CF1, CF2, and CF3, a color mixture defect visually recognized from a front or side of the display device may be prevented. A material of the light blocking layer BM is not particularly limited, and may be formed of various light blocking materials. For example, the light blocking layer BM may be implemented by stacking the first to third color filters CF1, CF2, and CF3 on each other.

An overcoat layer OC may be disposed on the color filter layer CFL. The overcoat layer OC may be provided over the first to third pixels PXL1, PXL2, and PXL3. The overcoat layer OC may cover a lower member including the color filter layer CFL. The overcoat layer OC may prevent moisture or air from penetrating into the above-described lower member. In addition, the overcoat layer OC may protect the above-described lower member from a foreign substance such as dust.

The overcoat layer OC may include an organic material such as an acrylates resin, an epoxy resin, a phenolic resin, a polyamides resin, a polyimides resin, a polyesters resin, a polyphenylenesulfides resin, or benzocyclobutene (BCB). However, the present disclosure is not limited thereto, and the overcoat layer OC may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), or titanium oxide (TiOx).

According to the above-described embodiment, the test electrodes TEL may be connected to the electrodes ALE through the test transistors TTR1 and TTR2, and thus the test signal may be applied to the test electrodes TEL only when the pre-alignment monitoring is required. Therefore, even though a short defect occurs between the test electrodes TEL, an effect on the alignment signal of the pixels PXL may be prevented, thereby preventing alignment deterioration.

Hereinafter, another embodiment is described. In the following embodiment, the same configurations as those already described are referred to by the same reference numerals, and a repeated description is omitted or simplified.

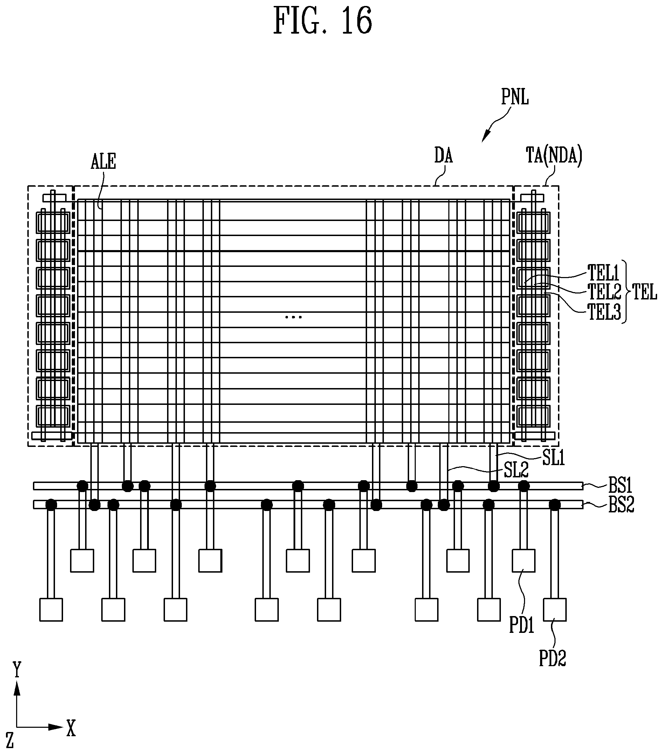

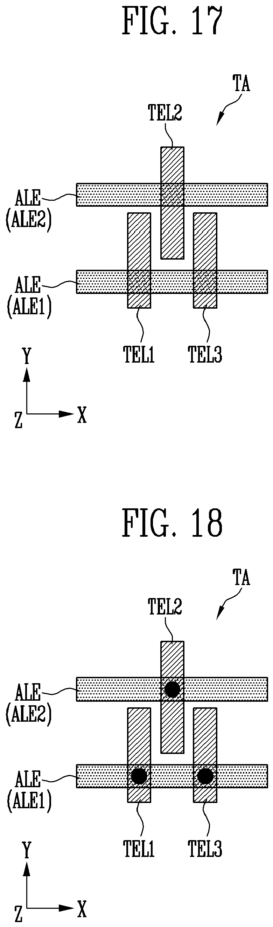

FIG. 16 is a plan view illustrating a display panel according to one or more embodiments. FIGS. 17 and 18 are plan views illustrating a test area according to one or more embodiments.

Referring to FIGS. 16 to 18, the electrodes ALE and the test electrodes TEL may at least partially overlap in the test area TA. For example, the first test electrode TEL1 and/or the third test electrode TEL3 may overlap the electrodes ALE (or the first electrode ALE1). The first test electrode TEL1 and/or the third test electrode TEL3 may be formed of a conductive layer different from that of the electrodes ALE (or the first electrode ALE1), but are/is not limited thereto. In addition, the second test electrode TEL2 may overlap the electrodes ALE (or the second electrode ALE2). The second test electrode TEL2 may be formed of a conductive layer different from that of the electrodes ALE (or the second electrode ALE2), but is not limited thereto.

According to one or more embodiments, when the pre-alignment monitoring is required, as shown in FIG. 18, the first test electrode TEL1 and/or the third test electrode TEL3 may contact the electrodes ALE (or the first electrode ALE1) through a contact hole. In addition, the second test electrode TEL2 may contact the electrodes ALE (or the second electrode ALE2) through a contact hole. For example, when only the pre-alignment monitoring is required, the test electrodes TEL may be connected to the electrodes ALE through laser repair. Accordingly, even though a short defect occurs between the test electrodes TEL, because an effect on the alignment signal of the pixels PXL may be prevented, alignment deterioration may be prevented.

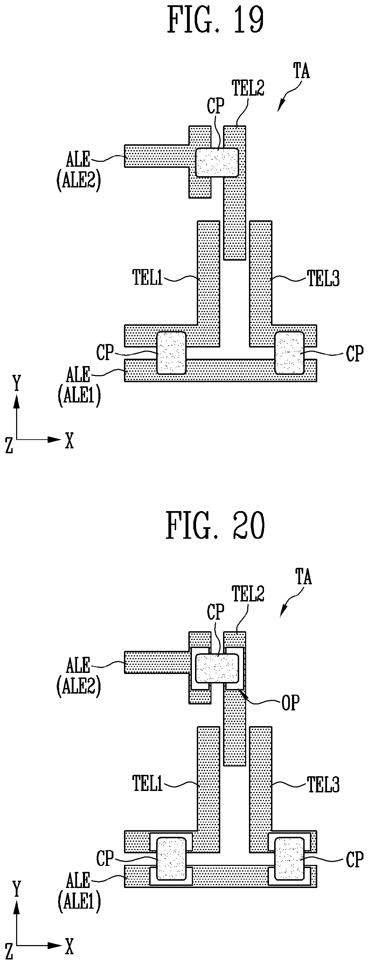

FIGS. 19 and 20 are plan views illustrating a test area according to one or more embodiments.

Referring to FIGS. 19 and 20, the electrodes ALE and the test electrodes TEL may be spaced from each other. The electrodes ALE and the test electrodes TEL may be formed of the same conductive layer, but are not limited thereto.

When the pre-alignment monitoring is required, a conductive pattern CP may be disposed between the electrodes ALE and the test electrodes TEL. The electrodes ALE and the test electrodes TEL may be connected through the conductive pattern CP. For example, the first test electrode TEL1 and/or the third test electrode TEL3 may be connected to the electrodes ALE (or the first electrode ALE1) through the conductive pattern CP. One end of the conductive pattern CP may be in contact with the first test electrode TEL1 and/or the third test electrode TEL3, and another end of the conductive pattern CP may be in contact with the electrodes ALE (or the first electrode ALE1). In addition, the second test electrode TEL2 may be connected to the electrodes ALE (or the second electrode ALE2) through the conductive pattern CP. One end of the conductive pattern CP may be in contact with the second test electrode TEL2, and another end of the conductive pattern CP may be in contact with the electrodes ALE (or the second electrode ALE2).

The conductive pattern CP may be formed on the electrodes ALE and/or the test electrodes TEL. That is, the conductive pattern CP may be formed of a conductive layer different from that of the electrodes ALE and/or the test electrodes TEL. In addition, the conductive pattern CP may be formed of a material different from that of the electrodes ALE and/or the test electrodes TEL. For example, the conductive pattern CP may be formed by applying silver (Ag) ink, but is not limited thereto.

According to one or more embodiments, as shown in FIG. 20, an open portion OP overlapping the conductive pattern CP may be formed after the pre-alignment monitoring. For example, the electrodes ALE may include the open portion OP overlapping the conductive pattern CP in the third direction (e.g., Z-axis direction). The electrodes ALE and the conductive pattern CP may be separated by the open portion OP. In addition, the test electrodes TEL may include the open portion OP overlapping the conductive pattern CP in the third direction (e.g., Z-axis direction). The test electrodes TEL and the conductive pattern CP may be separated by the open portion OP. As described above, when the conductive pattern CP connecting the electrodes ALE and the test electrodes TEL is separated by the open portion OP after the pre-alignment monitoring, even though a short defect occurs between the test electrodes TEL, an effect on the alignment signal of the pixels PXL may be reduced or prevented, and thus alignment deterioration may be prevented as described above.

Those skilled in the art may understand that the present disclosure may be implemented in a modified form without departing from the above-described essential characteristic. Therefore, the disclosed methods should be considered in a description point of view not a limitation point of view. The scope of the present disclosure is shown in the claims not in the above description, and all differences within the scope will be construed as being included in the disclosure.

## Claims

1. A display device comprising:
electrodes (ALE) spaced from each other in a display area (DA);
light emitting elements (LD) between the electrodes (ALE);
test electrodes (TEL) spaced from each other in a test area (TA); and
a test transistor (TTR1, TTR2) electrically connected to the electrodes (ALE) and the test electrodes (TEL).

2. The display device according to claim 1, wherein the electrodes and the test electrodes comprise a same conductive layer and/or extend in a same direction.

3. The display device according to claim 1 or 2, wherein a first transistor electrode of the test transistor is in contact with the test electrodes, and
a second transistor electrode of the test transistor is in contact with the electrodes.

4. The display device according to any preceding claim, further comprising:
a test line connected to the test transistor.

5. The display device according to claim 4, further comprising:
signal lines connected to the electrodes.

6. The display device according to claim 5, wherein the test line and the signal lines are electrically separated from each other.

7. The display device according to any one of claims 4, 5 or 6, further comprising:
a test pad connected to the test line.

8. The display device according to any preceding claim, further comprising:
connection electrodes on the light emitting elements to be in contact with the light emitting elements.

9. A display device as claimed in any preceding claim, further comprising:
a conductive pattern between the electrodes and the test electrodes.

10. The display device according to claim 9, wherein the electrodes and the test electrodes comprise a same conductive layer and/or are spaced from each other.

11. The display device according to claim 9 or 10, wherein the conductive pattern is on the electrodes and/or the test electrodes.

12. The display device according to any one of claims 9, 10 or 11, wherein one end of the conductive pattern is in contact with the electrodes, and another end of the conductive pattern is in contact with the test electrodes.

13. The display device according to any one of claims 9 to 12, wherein the electrodes include an open portion overlapping the conductive pattern; and/or
wherein the test electrodes include an open portion overlapping the conductive pattern; and/or
wherein the conductive pattern comprises a material that is different from that of the electrodes and/or the test electrodes.

14. A display device comprising:
a first electrode and a second electrode spaced from each other in a display area;
light emitting elements between the first and second electrodes; and
a first test electrode and a second test electrode spaced from each other in a test area,
wherein the first electrode at least partially overlaps the first test electrode, and
wherein the second electrode at least partially overlaps the second test electrode.

15. The display device according to claim 14, wherein the first electrode and the first test electrode comprise different conductive layers; and/or
wherein the first electrode is in contact with the first test electrode through a contact hole.
